# FASCICULE DE BREVET EUROPEEN

(11) **EP 2 662 899 B1**
(45) Date de publication et mention de la délivrance du brevet: **08.03.2017**
(21) Numéro de dépôt: 13166835.2
(22) Date de dépôt: 07.05.2013
(51) Int. Cl.: H01L 31/032, C23C 26/00, C23C 18/12, B82Y 30/00, B82Y 40/00

(54) **Procédé de fabrication d'un film de Cu2ZnSnS4 par SILAR**
Verfahren zur Herstellung einer Cu2ZnSnS4-Beschichtung durch die SILAR-Methode
Method for manufacturing a film of Cu2ZnSnS4 by SILAR

(30) Priorité: 09.05.2012 FR 1254222
(43) Date de publication de la demande: 13.11.2013
(73) Titulaire: COMMISSARIAT A L'ENERGIE ATOMIQUE ET AUX ENERGIES ALTERNATIVES, 75015 Paris (FR)
(72) Inventeur: Sanchez, Sylvia, 38410 VAULNAVEYS LE HAUT (FR); Ivanova-Hristova, Valentina, 38000 GRENOBLE (FR)
(74) Mandataire: Hautier, Nicolas

(56) Documents cités:
- SAWANTA S MALI ET AL: "Synthesis and characterization of CuZnSnSthin films by SILAR method", JOURNAL OF PHYSICS AND CHEMISTRY OF SOLIDS, PERGAMON PRESS, LONDON, GB, vol. 73, no. 6, 6 janvier 2012 (2012-01-06), pages 735-740, XP028464269, ISSN: 0022-3697, DOI: 10.1016/J.JPCS.2012.01.008 [extrait le 2012-01-20]
- SAWANTA S MALI ET AL: "Novel synthesis of kesterite CuZnSnSnanoflakes by successive ionic layer adsorption and reaction technique: Characterization and application", ELECTROCHIMICA ACTA, ELSEVIER SCIENCE PUBLISHERS, BARKING, GB, vol. 66, 22 janvier 2012 (2012-01-22), pages 216-221, XP028465046, ISSN: 0013-4686, DOI: 10.1016/J.ELECTACTA.2012.01.079 [extrait le 2012-02-01]
- ZHENGHUA SU ET AL: "Preparation of CuZnSnSthin films by sulfurizing stacked precursor thin films via successive ionic layer adsorption and reaction method", APPLIED SURFACE SCIENCE, ELSEVIER, AMSTERDAM, NL, vol. 258, no. 19, 19 avril 2012 (2012-04-19), pages 7678-7682, XP028505702, ISSN: 0169-4332, DOI: 10.1016/J.APSUSC.2012.04.120 [extrait le 2012-04-26]
- RAUL SALAZAR ET AL: "ZnO Nanowire Arrays Sensitized with Different Absorber Materials for Fabrication of Nanostructured Solar Cells", ECS TRANSACTIONS, vol. 41, no. 4, 1 janvier 2011 (2011-01-01), pages 119-128, XP055059378, ISSN: 1938-5862, DOI: 10.1149/1.3628616

## Description

### DOMAINE TECHNIQUE

La présente invention concerne un procédé de fabrication d'un film de Cu₂ZnSnS₄, aussi appelé CZTS, par adsorption et réaction de couches ioniques successives (SILAR en anglais : Successive Ion Layer Adsorption and Reaction).

Ce matériau à base d'éléments abondants et non toxiques présente les propriétés d'un semi-conducteur dont la bande interdite est d'environ 1,5 eV. Ce matériau est très intéressant pour des applications dans le domaine photovoltaïque, notamment pour la réalisation de cellules photovoltaïques à films minces ou en particulier nanostructurés comme la cellule ETA (Extremely Thin Absorber).

### ETAT DE LA TECHNIQUE

Des techniques de dépôts chimiques ou électrochimiques ont été utilisées telles que l'électrodépôt, le spray pyrolyse ou le bain chimique. Elles n'ont cependant pas permis de réaliser des films uniformes d'épaisseur contrôlée.

Le CZTS est également synthétisé à partir de réactions chimiques à l'état solide entre du sulfure de zinc (ZnS), du sulfure de cuivre (Cu₂S) et du sulfure d'étain (SnS₂). Toutefois, des impuretés telles que les composés ternaires et secondaires sont plus faciles à former que CZTS, il est donc difficile de n'obtenir que le CZTS.

On connaît également la méthode SILAR dans laquelle un substrat est immergé séparément dans deux solutions de précurseurs et rincé à l'eau entre chaque immersion. Un cycle SILAR consiste en l'adsorption de précurseurs cationiques puis l'adsorption de précurseurs anioniques avec une étape de rinçage intercalaire. Les précurseurs adsorbés vont réagir ensemble pour former le CZTS. Cette méthode a été explorée par Shinde et al (Room temperature novel chemical synthesis of Cu2ZnSnS4 (CZTS) absorbing layer for photovoltaic application. Materials Research Bulletin.) avec une solution cationique de 0,1 M de chlorure de cuivre (CuCl), 0,05 M de sulfate de zinc (ZnSO₄) et 0,05 de chlorure d'étain (SnCl₄) et une solution anionique de 0,2M de thioacétamide (C₂H₅NS). Le CZTS obtenu est riche en cuivre et non stoechiométrique. De plus, il est également formé des impuretés de CTS (Cu₂SnS₃). Cette solution cationique a un pH acide de 3 qui limite fortement le type de substrat pouvant être utilisé notamment elle peut dissoudre les oxydes métalliques.

Il existe donc le besoin de proposer un procédé qui remédie à tout ou partie de ces inconvénients.

### EXPOSE DE L'INVENTION

A cet effet, la présente invention concerne un procédé de fabrication d'un film de CZTS sur un substrat métallique ou d'oxyde métallique par SILAR.

Selon un aspect de l'invention, la solution cationique comprend des précurseurs : sulfate de cuivre (CuSO₄), du sulfate d'étain (SnSO₄) et du sulfate de zinc (ZnSO₄).

Le choix de ces précurseurs permet d'obtenir une solution cationique dont le pH, bien que restant acide, est de 5. A ce pH, la solution cationique peut être utilisée sur des substrats métalliques ou d'oxydes métalliques sans risque de les endommager.

Préférentiellement, dans un rapport de concentration des cations de Cu²⁺, Zn²⁺, Sn²⁺, de 1 : 0,5 : 0,5 ou de préférence 1 : 1 : 1. Avec ces rapports, la formation du CZTS est sous forme d'un film sans impureté.

Avantageusement, la solution anionique comprend du sulfure de sodium (Na₂S). Le rapport avec l'anion S²⁻ est de 1 :0,5 :0,5 : 1 ou bien 1 : 1 : 1 :1.

Selon un aspect de l'invention, les précurseurs de la solution cationique et anionique ont une concentration très faible de l'ordre de 5 à 20 mM.

D'autres buts et avantages apparaîtront au cours de la description qui suit qui présente un mode de réalisation détaillé de l'invention qui n'a cependant pas pour but de la limiter.

Auparavant, on introduit ci-après différents modes de réalisation avantageux mais non limitatifs de l'invention qui peuvent être mise en oeuvre alternativement ou cumulativement.

Pour rappel, la présente invention concerne un procédé de fabrication d'un film de Cu₂ZnSnS₄ (CZTS) sur un substrat métallique ou d'oxyde métallique par adsorption et réaction de couches ioniques successives (SILAR), caractérisé par le fait qu'il comprend au moins deux cycles, chaque cycle comprenant les étapes successives suivantes : immersion du substrat dans une solution cationique comprenant du sulfate de cuivre (CuSO₄), du sulfate d'étain (SnSO₄), du sulfate de zinc (ZnSO₄), dénommés les précurseurs ; rinçage par immersion du substrat dans de l'eau déionisée ; immersion du substrat dans une solution anionique comprenant du sulfure de sodium (Na₂S) ; rinçage par immersion du substrat dans de l'eau déionisée ; le rapport des concentrations des cations de cuivre (Cu²⁺), Zinc (Zn²⁺), et étain (Sn²⁺) et d'anion de soufre (S²⁻) est de 1 :1 :1 :1 ou 1 :0,5 :0,5 : 1.

Suivant des variantes additionnelles ou alternatives, le procédé est tel que :
- la concentration de chaque précurseur dans la solution cationique est comprise entre 5 et 20 mM ;
- la concentration du sulfure de sodium (Na₂S) dans la solution anionique est comprise entre 5 et 20mM ;
- les concentrations des précurseurs dans la solution cationique sont de 10mM de sulfate de cuivre, 10 mM de sulfate d'étain et 10 mM de sulfate de zinc ;
- dans la solution anionique, la concentration de sulfure de sodium est de 10 mM;
- la durée de l'immersion du substrat dans la solution cationique ou anionique est comprise entre 15 et 25 secondes
- la durée de l'immersion du substrat, avantageusement dans l'eau déionisée, pour le rinçage est supérieure ou égale à 15 secondes ;
- la solution cationique et/ou la solution anionique est une solution aqueuse ;
- la solution cationique a un pH de 5 ;
- la solution anionique a un pH de 12 ;
- il comprend après les au moins deux cycles, une étape de recuit, préférentiellement à 400°C, avantageusement sous atmosphère neutre par exemple sous vide ou sous flux d'argon ;
- le substrat est nanostructuré ;
- le substrat comporte des nanofils d'oxyde de zinc ;
- il comprend au moins quinze cycles, préférentiellement de quinze à vingt.

Suivant un autre aspect, l'invention concerne une surface nanostructurée recouverte d'un film homogène d'épaisseur minimale de 10 nm à une phase de CZTS obtenue par le procédé tel que décrit ci-avant.

Suivant un autre aspect, l'invention concerne des nanofils d'oxyde métallique recouverts d'un film homogène à une phase de CZTS obtenue par le procédé tel que décrit ci-avant.

### EXPOSE DETAILLE DE L'INVENTION

Le présent procédé permet la formation d'un film de Cu₂ZnSnS₄ aussi appelé CZTS. On entend par film, une mince pellicule d'une matière recouvrant une surface de manière continue. Avantageusement, le film est constitué d'une phase de Cu₂ZnSnS₄.

Un des avantages du procédé selon l'invention est de permettre la formation d'un film de Cu₂ZnSnS₄ sur un substrat métallique ou d'oxyde métallique. Avantageusement, le substrat est nanostructuré. On entend par nanostructuré que le substrat possède au moins une dimension variant entre 1 et une centaine de nanomètre. A titre d'exemple préféré, le substrat est sous forme de nanofils. Un nanofil est un fil dont le diamètre ne dépasse pas 500 nm.

Le substrat comprend par exemple de l'oxyde de zinc (ZnO), de l'oxyde de titane (TiO2), de l'oxyde étain-indium (ITO), de l'oxyde d'étain (SnO2), de l'oxyde de zinc dopé à aluminium (AZO), CuSCN, de l'acier, du Molybdène (Mo), du Cuivre (Cu), du sulfide de Cadium (CdS), du sulfide de zinc (ZnS)...

Le procédé de fabrication se base sur la technologie SILAR.

Le procédé comprend donc l'immersion successive du substrat dans une solution cationique, puis dans une solution anionique avec un rinçage intercalaire et un rinçage final.

Selon l'invention, l'ensemble des étapes d'un cycle est effectué à une température comprise entre 18 et 25° C.

On entend par immersion que le substrat est plongé dans un bain.

L'ensemble de ces quatre immersions constitue un cycle. Le procédé selon l'invention comprend au moins deux cycles, préférentiellement au moins quinze cycles, préférentiellement de quinze à vingt cycles. Le nombre de cycles dépend de l'épaisseur du film souhaité. Entre quinze et vingt cycles, l'épaisseur du film est satisfaisante pour former un film continu et homogène. Par exemple, en quinze cycles on obtient un film d'une épaisseur de 20nm.

On entend par homogène, que le film comprend une seule phase du CZTS, i.e. la phase CTS est inférieure à 5%.

Ainsi, avantageusement, le film est uniquement constitué d'une phase de CZTS. Selon un autre mode de réalisation, le film est constitué d'une phase de CZTS et d'une phase de CST dans une proportion inférieure à 5%.

L'épaisseur du film est régulière. A titre d'exemple, l'épaisseur est de minimum 10 nm à plus de 500 nm avec une variation de l'ordre de 5 nm. A titre d'exemple, pour une cellule ETA, on va chercher une épaisseur de 20-40 nm et pour une cellule à film mince une épaisseur supérieure à 500 nm. Les cycles sont répétés jusqu'à l'obtention de l'épaisseur souhaitée. Préférentiellement, les solutions sont renouvelées au-delà de quinze à vingt cycles pour maintenir une concentration des espèces et une vitesse de réaction constantes.

La solution cationique comprend des précurseurs du CZTS. Ces précurseurs présents dans la solution cationique sont des sulfates de métaux du CZTS. Plus précisément, la solution cationique comprend du sulfate de cuivre (CuSO₄), du sulfate de zinc (ZnSO₄) et du sulfate d'étain (SnSO₄). Les cations qui sont en solution dans la solution cationique sont les cations de zinc (Zn²⁺), d'étain (Sn²⁺), de cuivre (Cu²⁺).

Le choix de précurseurs métalliques de type sulfate contribue à obtenir une solution cationique dont le pH est acide et compatible avec des oxydes métalliques. A titre préféré, le pH est de l'ordre de 5.

Les concentrations des cations des précurseurs sont particulièrement étudiées dans le présent procédé. Préférentiellement, les concentrations sont faibles, avantageusement une solution cationique comprend entre 5 et 20 mM de chaque précurseur.

De manière surprenante, le procédé selon l'invention donne un film de CZTS satisfaisant pour des rapports de cations de Cu²⁺, Sn²⁺ et Zn²⁺ respectivement de 1 : 0,5 : 0,5 ou de préférence 1 : 1 : 1. Il est préféré que les cations d'étain et de zinc soient en concentration équivalente. La concentration de cation de cuivre est soit équivalente, soit deux fois plus importante. Ces rapports sont très intéressants.

Seul un rapport de 1 : 1 : 1 ou 1 : 0,5 : 0,5 permet d'obtenir un film homogène avec une seule phase de CZTS.

La solution anionique comprend avantageusement du sulfure de sodium (Na₂S). La concentration de sulfure de sodium dans la solution anionique est avantageusement assez faible, préférentiellement comprise entre 5 mM et 20 mM. La solution anionique est avantageusement constituée de sulfure de sodium (Na₂S) dilué dans l'eau.

Selon l'invention, les concentrations des précurseurs et du sulfure de sodium sont choisies de sorte que le rapport des concentrations des cations Cu²⁺, Sn²⁺ et Zn²⁺ et de l'anion S²⁻ soit de 1 : 0,5 : 0,5 : 1 ou bien 1 : 1 : 1 : 1.

La formation de CZTS ne dépend pas linéairement des concentrations des espèces cationiques et anioniques. Notamment, l'existence d'une phase CTS majoritaire dans l'état de la technique n'est pas résolue par un excès de zinc par rapport à l'étain, au contraire la phase CTS est renforcée.

La solution (Na₂S) est très stable dans le temps. Le pH de la solution est de l'ordre de 12. Le pH élevé de la solution anionique n'est pas gênant pour le substrat. Le sulfure de sodium n'attaque pas la surface du substrat car les anions S²⁻ s'adsorbent sur la couche cationique formée lors de l'immersion du substrat dans la solution cationique. La couche cationique joue le rôle protecteur du substrat.

Les solutions cationique et anionique sont avantageusement des solutions aqueuses, les précurseurs cationiques et le sulfure de sodium étant mis en solution dans de l'eau déionisée.

Pour obtenir un film continu et homogène, le temps d'immersion du substrat dans les solutions est un paramètre qui a été particulièrement étudié.

La durée de l'immersion du substrat dans la solution cationique est avantageusement comprise entre 15 et 25 secondes. Il n'est pas nécessaire de laisser le substrat tremper longtemps pour obtenir une couche cationique continue et homogène. On évite ainsi la formation de trop grosses particules générant un relief important. A titre préféré, des nanoparticules sont formées dont le diamètre est de l'ordre de 5 nm.

Les étapes de rinçage dans lesquelles le substrat est immergé dans un bain, avantageusement d'eau déionisée, jouent un rôle important pour la formation du film continu et homogène. Le rinçage doit permettre de retirer les espèces en excès.

La durée de l'immersion est donc contrôlée. Avantageusement, elle dure au moins 15 secondes, préférentiellement 20 secondes.

Pour caractériser la surface du substrat et suivre la formation d'un film de CZTS, on utilise le microscope électronique à balayage (MEB) ou la microscopie électronique en transmission à balayage (STEM).

On peut voir sur les images ci-après des nanofils de ZnO recouverts de Cu₂ZnSnS₄. Pour détecter la phase CZTS, la technique de diffraction des rayons X n'est pas assez spécifique car les pics de diffraction du CZTS sont très proches voire confondus à ceux des phases secondaires et tertiaires. La technique Raman est préférée pour différencier les phases secondaires et tertiaires de la phase quaternaire du CZTS.

### EXEMPLES

Le procédé selon l'invention a été utilisé pour former un dépôt de CZTS par voie SILAR sur des nanofils de ZnO. Avec une durée d'immersion dans les solutions cationique puis anionique de 20 secondes chacune et une durée d'immersion pour le rinçage de 20 secondes dans un bain d'eau déionisée.

**Tableau 1 : Description des différents procédés utilisés pour le dépôt de CZTS par voie SILAR.**

| ***Procédé*** | ***Solution cationique*** | | | ***Solution anionique*** |
|---|---|---|---|---|
| **P2** | 5 mM CuSO₄ | 5 mM SnSO₄ | 10 mM ZnSO₄ | 10 mM Na₂S |
| **P3** | 10 mM CuSO₄ | 5 mM SnSO₄ | 10 mM ZnSO₄ | 10 mM Na₂S |
| **P4** | 10 mM CuSO₄ | 5 mM SnSO₄ | 5 mM ZnSO₄ | 10 mM Na₂S |
| **P5** | 10 mM CuSO₄ | 10 mM SnSO₄ | 10 mM ZnSO₄ | 10 mM Na₂S |

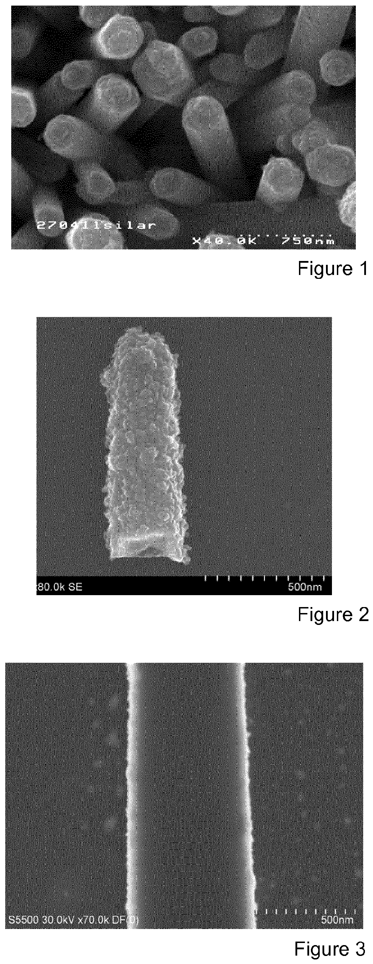

**Figure 1** **:** Image MEB vue de dessus de Cu₂ZnSnS₄ déposé par SILAR sur ZnO suivant le procédé P5.
**Figure 2 et 3** **:** Image STEM d'une structure coeur nanofils ZnO/coquille Cu₂ZnSnS₄ suivant le procédé P5.
   Des analyses par la technique Raman ont été effectuées sur les films de CZTS obtenus par les procédés du tableau 1.

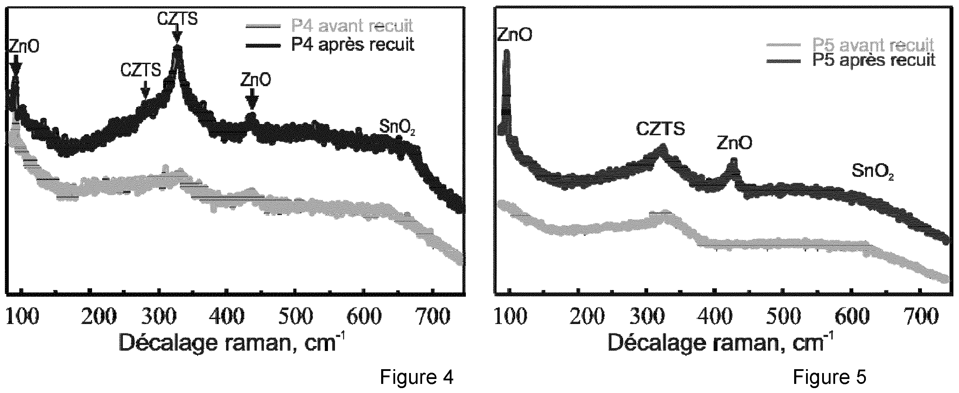

**Figures 4 et 5** Ces deux spectres correspondent aux films de CZTS obtenus respectivement par les procédés P4 et P5 du tableau 1 sans étape de recuit et après recuit à 400°C sous flux d'Argon pendant 1h.
   On observe une phase majoritaire de CZTS. Avec le procédé P4, on obtient une phase majoritaire de CZTS, d'au moins de 95%. Avec le procédé P5, on obtient une seule phase de CZTS à 100% CZTS. Le pic est moins intense car le film doit être légèrement plus mince et peut être moins cristallisé.

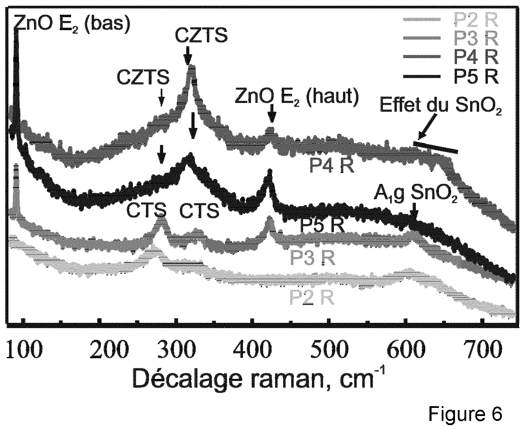

**Figure 6** Ce spectre correspond aux films de CZTS obtenus respectivement par les procédés P2, P3, P4 et P5 du tableau 1 après une étape de recuit à 400°C sous flux d'argon. On observe une phase majoritaire de CZTS pour P4 et P5 mais pas pour P2 et P3 où la phase majoritaire est le CTS

## Revendications

1. Procédé de fabrication d'un film de Cu₂ZnSnS₄ (CZTS) sur un substrat métallique ou d'oxyde métallique par adsorption et réaction de couches ioniques successives (SILAR),
**caractérisé par le fait qu'**il comprend au moins deux cycles, chaque cycle comprenant les étapes successives suivantes :
- immersion du substrat dans une solution cationique comprenant du sulfate de cuivre (CuSO₄), du sulfate d'étain (SnSO₄), du sulfate de zinc (ZnSO₄), dénommés les précurseurs ;
- rinçage par immersion du substrat dans de l'eau déionisée ;
- immersion du substrat dans une solution anionique comprenant du sulfure de sodium (Na₂S) ;
- rinçage par immersion du substrat dans de l'eau déionisée ;
le rapport des concentrations des cations de cuivre (Cu²⁺), Zinc (Zn²⁺), et étain (Sn²⁺) et d'anion de soufre (S²⁻) est de 1 :1 :1 :1 ou 1 :0,5 :0,5 : 1.

2. Procédé selon la revendication précédente dans lequel la concentration de chaque précurseur dans la solution cationique est comprise entre 5 et 20 mM.

3. Procédé selon l'une quelconque des revendications précédentes dans lequel la concentration du sulfure de sodium (Na₂S) dans la solution anionique est comprise entre 5 et 20mM.

4. Procédé selon l'une quelconque des revendications précédentes dans lequel les concentrations des précurseurs dans la solution cationique sont de 10mM de sulfate de cuivre (CuSO₄), 10 mM de sulfate d'étain (SnSO₄) et 10 mM de sulfate de zinc(ZnSO₄).

5. Procédé selon l'une quelconque des revendications précédentes dans lequel la concentration de sulfure de sodium (Na₂S) dans la solution anionique est de 10 mM.

6. Procédé selon l'une quelconque des revendications précédentes dans lequel la durée de l'immersion du substrat dans la solution cationique ou anionique est comprise entre 15 et 25 secondes.

7. Procédé selon l'une quelconque des revendications précédentes dans lequel la durée de l'immersion du substrat dans l'eau déionisée pour le rinçage est supérieure ou égale à 15 secondes.

8. Procédé selon l'une quelconque des revendications précédentes dans lequel la solution cationique et/ou la solution anionique est une solution aqueuse.

9. Procédé selon l'une quelconque des revendications précédentes dans lequel la solution cationique a un pH de 5.

10. Procédé selon l'une quelconque des revendications précédentes dans lequel la solution anionique a un pH de 12.

11. Procédé selon l'une quelconque des revendications précédentes qui comprend après les au moins deux cycles, une étape de recuit à 400°C sous atmosphère neutre.

12. Procédé selon l'une quelconque des revendications précédentes dans lequel le substrat est nanostructuré.

13. Procédé selon l'une quelconque des revendications précédentes dans lequel le substrat comporte des nanofils d'oxyde de zinc.

14. Procédé selon l'une quelconque des revendications précédentes comprenant au moins quinze cycles, préférentiellement de quinze à vingt.

15. Surface nanostructurée recouverte d'un film homogène d'épaisseur minimale de 10 nm à une phase de CZTS obtenue par le procédé selon l'une quelconque des revendications précédentes, ledit film comprenant moins de 5% de phase CTS.

16. Nanofils d'oxyde métallique recouverts d'un film homogène à une phase de CZTS obtenue par le procédé selon l'une quelconque des revendications 1 à 14, ledit film comprenant moins de 5% de phase CTS.

## Patentansprüche

1. Verfahren zur Herstellung eines Films aus Cu₂ZnSnS₄ (CZTS) auf einem metallischen oder aus Metalloxid bestehenden Substrat durch sukzessive Adsorption und Reaktion ionischer Schichten (SILAR),
**dadurch gekennzeichnet, dass** es wenigstens zwei Zyklen umfasst, wobei jeder Zyklus die folgenden aufeinander folgenden Schritte umfasst:
- Eintauchen des Substrats in eine kationische Lösung, die Kupfersulfat (CuSO₄), Zinnsulfat (SnSO₄) und Zinksulfat (ZnSO₄), die Precursoren genannt, umfasst;
- Spülen durch Eintauchen des Substrats in entionisiertes Wasser;
- Eintauchen des Substrats in eine anionische Lösung, die Natriumsulfid (Na₂S) umfasst;
- Spülen durch Eintauchen des Substrats in entionisiertes Wasser;
wobei das Verhältnis der Konzentrationen der Kationen von Kupfer (Cu²⁺), Zink (Zn²⁺) und Zinn (Sn²⁺) und des Anions von Schwefel (S²⁻) 1:1:1:1 oder 1:0,5:0,5:1 beträgt.

2. Verfahren nach dem vorhergehenden Anspruch, wobei die Konzentration jedes Precursors in der kationischen Lösung zwischen 5 und 20 mM liegt.

3. Verfahren nach einem der vorhergehenden Ansprüche, wobei die Konzentration von Natriumsulfid (Na₂S) in der anionischen Lösung zwischen 5 und 20 mM liegt.

4. Verfahren nach einem der vorhergehenden Ansprüche, wobei die Konzentrationen der Precursoren in der kationischen Lösung 10 mM Kupfersulfat (CuSO₄), 10 mM Zinnsulfat (SnSO₄) und 10 mM Zinksulfat (ZnSO₄) betragen.

5. Verfahren nach einem der vorhergehenden Ansprüche, wobei die Konzentration von Natriumsulfid (Na₂S) in der anionischen Lösung 10 mM beträgt.

6. Verfahren nach einem der vorhergehenden Ansprüche, wobei die Dauer des Eintauchens des Substrats in die kationische oder anionische Lösung zwischen 15 und 25 Sekunden liegt.

7. Verfahren nach einem der vorhergehenden Ansprüche, wobei die Dauer des Eintauchens des Substrats in das entionisierte Wasser zum Spülen größer oder gleich 15 Sekunden ist.

8. Verfahren nach einem der vorhergehenden Ansprüche, wobei die kationische Lösung und/oder die anionische Lösung eine wässrige Lösung ist.

9. Verfahren nach einem der vorhergehenden Ansprüche, wobei die kationische Lösung einen pH-Wert von 5 hat.

10. Verfahren nach einem der vorhergehenden Ansprüche, wobei die anionische Lösung einen pH-Wert von 12 hat.

11. Verfahren nach einem der vorhergehenden Ansprüche, welches nach den wenigstens zwei Zyklen einen Schritt des Glühens bei 400°C unter neutraler Atmosphäre umfasst.

12. Verfahren nach einem der vorhergehenden Ansprüche, wobei das Substrat nanostrukturiert ist.

13. Verfahren nach einem der vorhergehenden Ansprüche, wobei das Substrat Nanodrähte aus Zinkoxid aufweist.

14. Verfahren nach einem der vorhergehenden Ansprüche, welches wenigstens fünfzehn Zyklen umfasst, vorzugsweise fünfzehn bis zwanzig.

15. Nanostrukturierte Oberfläche, die mit einem homogenen Film mit einer minimalen Dicke von 10 nm mit einer Phase aus CZTS bedeckt ist, die mit dem Verfahren nach einem der vorhergehenden Ansprüche erhalten wurde, wobei der Film weniger als 5 % an CTS-Phase umfasst.

16. Metalloxid-Nanodrähte, die mit einem homogenen Film mit einer Phase aus CZTS bedeckt sind, die mit dem Verfahren nach einem der Ansprüche 1 bis 14 erhalten wurde, wobei der Film weniger als 5 % an CTS-Phase umfasst.

## Claims

1. A method for manufacturing a film of Cu₂ZnSnS₄ (CZTS) on a metal or metal oxide substrate by successive ion layer adsorption and reaction (SILAR), wherein the method comprises at least two cycles, each cycle comprising, in the following order:
immersing the substrate in a cationic solution comprising copper sulfate (CuSO₄), tin sulfate (SnSO₄) and zinc sulfate (ZnSO₄), as precursors;
rinsing, by immersion, the substrate in deionized water;
immersing the substrate in an anionic solution comprising sodium sulfide (Na₂S); and
rinsing, by immersion, the substrate in deionized water;
wherein a concentration ratio of copper (Cu²⁺), zinc (Zn²⁺) and tin (Sn²⁺) cations and of sulfur anion (S²⁻) anion is 1: 1 : 1 : 1 or 1 : 0.5 : 0.5 : 1.

2. The method according to the preceding claim, wherein a concentration of each precursor in the cationic solution is between 5 and 20 mM.

3. The method according to any of the preceding claims, wherein a concentration of sodium sulfide (Na₂S) in the anionic solution is between 5 and 20 mM.

4. The method according to any of the preceding claims, wherein the concentrations of the precursors in the cationic solution are 10 mM copper sulfate (CuSO₄), 10 mM tin sulfate (SnSO₄) and 10 mM zinc sulfate (ZnSO₄).

5. The method according to any of the preceding claims, wherein a concentration of sodium sulfide (Na₂S) in the anionic solution is 10 mM.

6. The method according to any of the preceding claims, wherein a duration of immersion of the substrate in the cationic or anionic solution is between 15 and 25 seconds.

7. The method according to any of the preceding claims, wherein a duration of immersion of the substrate in the deionized water for rinsing is longer than or equal to 15 seconds.

8. The method according to any of the preceding claims, wherein the cationic solution, the anionic solution, or both, is an aqueous solution.

9. The method according to any of the preceding claims, wherein the cationic solution has a pH of 5.

10. The method according to any of the preceding claims, wherein the anionic solution has a pH of 12.

11. The method according to any of the preceding claims, further comprising, after the at least two cycles, annealing at 400°C under a neutral atmosphere.

12. The method according to any of the preceding claims, wherein the substrate is nanostructured.

13. The method according to any of the preceding claims, wherein the substrate comprises nanowires of zinc oxide.

14. The method according to any of the preceding claims, comprising at least fifteen cycles, preferably from fifteen to twenty.

15. A nanostructured surface covered by a homogeneous film having a minimum thickness of 10 nm of a CZTS phase obtained by the method according to any of the preceding claims, said film comprising less than 5% of CTS phase.

16. A nanowire of metal oxide covered by a homogeneous film of a CZTS phase obtained by the method according to any of claims 1 to 14, said film comprising less than 5% of CTS phase.
